# EUROPÄISCHE PATENTSCHRIFT

(11) **EP 2 376 932 B1**
(45) Veröffentlichungstag und Bekanntmachung des Hinweises auf die Patenterteilung: **02.04.2014**
(21) Anmeldenummer: 09806012.2
(22) Anmeldetag: 09.12.2009
(51) Int. Cl.: G01R 33/09, G07D 7/04

(54) **MAGNETSENSOR ZUR PRÜFUNG VON WERTDOKUMENTEN**
MAGNETIC SENSOR FOR CHECKING VALUE DOCUMENTS
DÉTECTEUR MAGNÉTIQUE POUR LE CONTRÔLE DE DOCUMENTS DE VALEUR

(30) Priorität: 10.12.2008 DE 102008061507
(43) Veröffentlichungstag der Anmeldung: 19.10.2011
(73) Patentinhaber: Giesecke & Devrient GmbH, 81677 München (DE)
(72) Erfinder: SCHÜTZMANN, Jürgen, 85276 Pfaffenhofen (DE); PAUL, Elisabeth, 83064 Raubling (DE)
(86) Internationale Anmeldenummer: PCT/EP2009/066709
(87) Internationale Veröffentlichungsnummer: WO 2010/066779

(56) Entgegenhaltungen:
- WO-A1-98/38792
- DE-A1- 10 244 740
- DE-A1-102004 049 999
- US-B1- 6 822 443
- US-B1- 7 157 905

## Beschreibung

Die Erfindung betrifft einen Magnetsensor sowie eine Vorrichtung und ein Verfahren zur Prüfung von Wertdokumenten. Bei dem Wertdokument kann es sich um Banknoten, Ausweisdokumente, Scheckkarten, Kreditkarten Aktien, Urkunden, Briefmarken, Schecks, Eintrittskarten, Fahrkarten, Flugscheine, Ausweise, Visasticker, Etiketten, Siegel, Verpackungen oder andere derartige Elemente handeln. Die vereinfachende Benennung Wertdokument schließt deshalb im Folgenden stets Dokumente der genannten Art ein.

Aus der US6822443 B1 ist ein Magnetsensor zur Prüfung von Münzen bekannt, der magnetoresistive Elemente dazu verwendet, die Münzen anhand des induzierten Wirbelstroms auf ihre elektrische Leitfähigkeit zu prüfen. Die magnetoresistiven Elemente weisen zwei zueinander senkrechte Empfindlichkeitsrichtungen auf.

Aus der US7157905 B1 ist ein Magnetsensor zur Prüfung von Banknoten bekannt mit einer Zeile magnetoresistiver Elemente. Aus der DE10244740 A1 ist ein Magnetsensor zur Prüfung von Magnetkarten bekannt, der zwei Zeilen magnetoresistiver Elemente aufweist, die quer zur Transportrichtung der Magnetkarte angeordnet sind, um Magnetstrukturen der Magnetkarte zu prüfen. Die WO98/38792 A1 offenbart eine Vorrichtung zur Prüfung von Wertdokumenten mit zwei einander gegenüber liegenden Zeilen aus magnetoresistiven Elemente, um das Wertdokument magnetisch zu prüfen. Aus der DE102004049999 A1 ist eine Vorrichtung zur Prüfung von Wertdokumenten bekannt, die zwei Magnetisierungseinrichtungen zum Magnetisieren des Wertdokumentes und einen Magnetsensor zum Detektieren von Magnetsignalen des Wertdokuments aufweist. Die magnetosensitiven Elemente dieser Magnetsensoren weisen jedoch keine verschiedenen Empfindlichkeitsrichtungen auf. Außerdem werden dort keine drei verschiedenen Magnetisierungsabschnitte zum Magnetisieren des Wertdokuments verwendet.

Aus dem Stand der Technik ist es bekannt, Wertdokumente mit Sicherheitselementen, etwa Sicherheitsstreifen oder auch Sicherheitsfäden, auszustatten, die magnetisches Material enthalten. Das magnetische Material kann dabei entweder durchgehend oder nur bereichsweise, zum Beispiel in Form einer Kodierung auf das Sicherheitselement aufgebracht sein. Zur magnetischen Kodierung eines Sicherheitselements dient beispielsweise eine bestimmte Abfolge von magnetischen und nichtmagnetischen Bereichen, die charakteristisch für Art des zu sichernden Wertdokuments ist. Außerdem ist es bekannt, verschiedene magnetische Materialien für eine Magnetkodierung zu verwenden, beispielsweise mit unterschiedlichen Koerzitivfeldstärken. Bei den bisher bekannten magnetischen Kodierungen werden beispielsweise zwei verschieden koerzitive magnetische Materialien eingesetzt, aus welchen zwei Sorten von Magnetbereichen gebildet werden, die nebeneinander oder auch übereinander angeordnet sein können.

Des Weiteren ist es bekannt, Banknoten mit Sicherheitsfäden, die eine Magnetkodierung aus verschieden koerzitiven Materialien aufweisen, maschinell zu prüfen. Dabei werden die Banknoten parallel zum Verlauf des Sicherheitselements transportiert und durchlaufen nacheinander zuerst ein starkes Magnetfeld parallel zur Transportrichtung, das sowohl die hoch- als auch die niederkoerzitiven Magnetbereiche entlang der Transportrichtung magnetisiert. Die verbleibende Magnetisierung wird mittels eines induktiven Magnetkopfs, der ausschließlich parallel zur Transportrichtung empfindlich ist, geprüft. Anschließend durchlaufen die Banknoten ein schwächeres Magnetfeld senkrecht zur Transportrichtung, das nur die niederkoerzitiven Magnetbereiche senkrecht zur Transportrichtung ausrichtet, während die hochkoerzitiven Magnetbereiche in Transportrichtung magnetisiert bleiben. Wiederum wird die verbleibende Magnetisierung mittels eines induktiven Magnetkopfs, der ausschließlich parallel zur Transportrichtung empfindlich ist, geprüft. Mit dem ersten induktiven Magnetkopf werden dabei die hoch- und die niederkoerzitiven Magnetbereiche detektiert und mit dem zweiten induktiven Magnetkopf werden nur die hochkoerzitiven Magnetbereiche detektiert. Falls jedoch verschieden koerzitive Magnetbereiche zugleich in den Detektionsbereich des Magnetsensors gelangen, detektiert dieser Magnetsensor eine Überlagerung der Magnetsignale der verschieden koerzitiven Magnetbereiche. Nachteilig ist bei diesem Verfahren, dass Magnetbereiche, die sowohl hoch- als auch niederkoerzitives Magnetmaterial enthalten, nur schwer von einzelnen hochkoerzitiven oder niederkoerzitiven Magnetbereichen unterschieden werden können.

Der Erfindung liegt daher die Aufgabe zugrunde, einen Magnetsensor anzugeben, mit dem Wertdokumente, die verschieden koerzitive Magnetbereiche aufweisen, insbesondere Wertdokumente mit Magnetkodierungen aus verschieden koerzitiven Magnetmaterialien, zuverlässig erkannt und voneinander unterschieden werden können.

Die Aufgabe der Erfindung wird durch den Magnetsensor sowie die Vorrichtung und das Verfahren der unabhängigen Ansprüche gelöst. Weiterbildungen der Erfindung sind Gegenstand der Unteransprüche.

Die erfindungsgemäße Vorrichtung weist ein Transportsystem auf, mittels dem ein Wertdokument, das in der Vorrichtung geprüft wird, entlang eines Transportwegs in der Vorrichtung transportiert wird. Entlang des Transportwegs des Wertdokuments sind ein erster und ein zweiter Magnetisierungsabschnitt zur Magnetisierung des Wertdokuments angeordnet, die beispielsweise durch eine Magnetisierungseinrichtung bereit gestellt werden, und ein Magnetsensor, der Magnetsignale des Wertdokuments detektiert, um die Magnetisierung des Wertdokuments zu bestimmen. Die Magnetisierungseinrichtung ist dabei entlang des Transportwegs vor dem Magnetsensor angeordnet.

Der erfindungsgemäße Magnetsensor weist eine erste und eine zweite Sensorzeile auf, die jeweils mehrere magnetosensitive Elemente enthalten, insbesondere eine Zeile gleichartiger magnetosensitiver Elemente, die entlang einer Linie quer, insbesondere senkrecht, zur Transportrichtung des Wertdokuments angeordnet sind. Die magnetosensitiven Elemente der ersten Sensorzeile besitzen jeweils dieselbe Hauptempfindlichkeitsrichtung. Auch die magnetosensitiven Elemente der zweiten Sensorzeile besitzen jeweils dieselbe Hauptempfindlichkeitsrichtung. Die magnetosensitiven Elemente der ersten Sensorzeile weisen eine erste Hauptempfindlichkeitsrichtung auf und die magnetosensitiven Elemente der zweiten Sensorzeile weisen eine zweite Hauptempfindlichkeitsrichtung auf, die von der ersten Hauptempfindlichkeitsrichtung verschieden ist. Beispielsweise sind die erste und die zweite Hauptempfindlichkeitsrichtung senkrecht zueinander orientiert und liegen in der Transportebene des Wertdokuments. Im Wesentlichen detektierten die magnetosensitiven Elemente nur Magnetfelder, deren Richtung entlang der Hauptempfindlichkeitsrichtung des jeweiligen magnetosensitiven Elements weist. Senkrecht dazu orientierte Magnetfelder liefern kein Magnetsignal bzw. nur ein schwaches Magnetsignal, dessen Höhe unterhalb eines vorgegebenen Schwellenwerts liegt. Die magnetosensitiven Elemente detektieren also im Wesentlichen Magnetsignale von Magnetbereichen, deren Magnetisierung parallel oder antiparallel zur Hauptempfindlichkeitsrichtung des jeweiligen magnetosensitiven Elements orientiert ist.

Die magnetosensitiven Elemente sind vorzugsweise jeweils so entlang der ersten bzw. zweiten Sensorzeile angeordnet, dass möglichst keine oder möglichst kleine Lücken dazwischen verbleiben. Außerdem sind die magnetosensitiven Elemente der beiden Sensorzeilen bevorzugt so zueinander angeordnet, dass jeweils ein magnetosensitives Element der ersten Sensorzeile mit einem magnetosensitiven Element der zweiten Sensorzeile korrespondiert, d.h. dass an diesen beiden magnetosensitiven Elemente im Wesentlichen derselben Teilbereich des Wertdokuments vorbeitransportiert wird. Die jeweils zwei miteinander korrespondierenden magnetosensitiven Elemente definieren eine Messspur. Für die erste und zweite Sensorzeile können als magnetosensitive Elemente beispielsweise magnetoresistive Elemente, induktive Elemente oder Hall-Elemente verwendet werden.

Vorzugsweise sind die magnetosensitiven Elemente der ersten und zweiten Sensorzeile als magnetoresistive Elemente ausgebildet. Die magnetoresistiven Elemente können durch ein Vorspannungsmagnetfeld magnetisch vorgespannt sein, um einen geeigneten Arbeitspunkt auf deren Widerstandskennlinie einzustellen. Zumindest eine Richtungskomponente des Vorspannungsmagnetfelds ist dabei parallel oder antiparallel zur Hauptempfindlichkeitsrichtung des jeweils magnetisch vorzuspannenden magnetoresistiven Elements orientiert. Zur Realisierung der geringfügigen magnetischen Vorspannung kann ein Permanentmagnet oder ein stromdurchflossener elektrischer Leiter so in der Nähe des jeweiligen magnetoresistiven Elements angeordnet werden, dass durch den Permanentmagnet bzw. bei Stromfluss durch den Leiter, ein Vorspannungsmagnetfeld erzeugt wird, das die magnetoresistiven Elemente magnetisch vorspannt. Beispielsweise sind die magnetoresistiven Elemente der ersten und zweiten Sensorzeile als GMR-Elemente (GMR: giant magneto resistance) ausgebildet, sie können aber auch als AMR-Elemente (AMR: anisotropic magneto resistance), TMR-Elemente (tunneling magneto resistance), SdT-Elemente (Spin-dependent-tunneling), Spinventil-Elemente oder als konventionelle Magnetowiderstandselemente ausgebildet sein, die auf Basis des allgemeinen Magnetowiderstands (ordinary magnetoresistance) funktionieren, oder als sonstige magnetoresistive Elemente. Falls als magnetoresistive Elemente der ersten und zweiten Sensorzeile GMR-, AMR-, TMR-, SdT- oder Spinventil-Elemente, verwendet werden, werden diese vorzugsweise geringfügig magnetisch vorgespannt, wobei die Magnetfeldstärke der geringfügigen magnetischen Vorspannung kleiner als 8 kA/m, insbesondere kleiner als 5 kA/m ist. GMR-Elemente können z.B. ein Schichtsystem aus ferromagnetischen und nicht-magnetischen Metallschichten aufweisen, das mäanderförmig strukturiert ist. Die Hauptempfindlichkeitsrichtung der GMR-Elemente ist dabei durch die Längsrichtung der mäanderförmigen Struktur definiert. Bei konventionellen Magnetowiderstandselementen ist die Hauptempfindlichkeitsrichtung beispielsweise senkrecht zur Ebene der Magnetowiderstandsschicht orientiert.

Der Magnetsensor kann, entlang des Transportwegs betrachtet, an einer beliebigen Stelle nach der Magnetisierungseinrichtung angeordnet werden. In einigen Ausführungsbeispielen sind der Magnetsensor und die Magnetisierungseinrichtung entlang des Transportwegs räumlich getrennt voneinander angeordnet, wobei der Magnetsensor und die Mägnetisierungseinrichtung z.B. räumlich voneinander getrennt in die Vorrichtung eingebaut sind. Bei begrenztem Platzangebot in der Vorrichtung kann es vorteilhaft sein, die Magnetisierungseinrichtung und den Magnetsensor nicht unmittelbar nacheinander anzuordnen, sondern jeweils dort, wo entsprechend Platz innerhalb der Vorrichtung vorhanden ist. Die räumlich getrennte Anordnung erlaubt mehr Flexibilität bei der Anordnung der beiden Komponenten innerhalb der Vorrichtung. Außerdem kann die Magnetisierungseinrichtung dann unabhängig von dem Magnetsensor eingebaut werden. Bei entsprechend viel Platz in der Vorrichtung können die Magnetisierungseinrichtung und der Magnetsensor aber auch unmittelbar nacheinander entlang des Transportwegs angeordnet werden. Auch dabei können sie als zwei voneinander getrennte Komponenten eingebaut sein oder, alternativ, innerhalb derselben Komponente, insbesondere in einem gemeinsamen Gehäuse.

Das Wertdokument wird entlang des Transportwegs in eine Transportrichtung transportiert, die an verschiedenen Positionen entlang des Transportwegs in verschiedene Raumrichtungen weisen kann. Beim Transportieren des Wertdokuments spannt das Wertdokument eine Transportebene auf, die an verschiedenen Positionen entlang des Transportwegs verschiedene räumliche Lagen annehmen kann, so z.B. im Fall von Umlenkungen des Transportwegs. In dieser Anmeldung beziehen sich Richtungsangaben, die die Hauptempfindlichkeitsrichtung der magnetosensitiven Elemente der Sensorzeilen bzw. die Magnetisierungsrichtungen der Magnetisierüngsabschnitte betreffen und die in Bezug auf die Transportrichtung bzw. auf die Transportebene angegeben sind, stets auf die jeweilige Transportrichtung bzw. auf die jeweilige Transportebene des Wertdokuments am Ort der jeweiligen Sensorzeile bzw. am Ort des jeweiligen Magnetisierungsabschnitts.

Nachdem das Wertdokument durch die Magnetisierungsabschnitte magnetisiert wurde, kann sich entlang des Transportwegs, aufgrund von Änderungen der Transportrichtung, die Lage der Magnetisierungsrichtung im Raum verändern. Da die Magnetisierung eine physikalische Eigenschaft des magnetisierten Wertdokuments ist, bleibt jedoch die Orientierung der Magnetisierung bezüglich des Wertdokuments auch bei Umlenkungen des Transportwegs bestehen. An der Position der jeweiligen Sensorzeile ist daher ist die Richtung der Magnetisierung, die ein herantransportiertes Wertdokument mit sich bringt, durch die Transportlage des herantransportierten Wertdokuments definiert. Wenn im Folgenden die Hauptempfindlichkeitsrichtung einer Sensorzeile in Bezug zur Magnetisierungsrichtung gesetzt wird, z.B. dass diese parallel zueinander sind, so bedeutet dies, dass die Hauptempfindlichkeitsrichtung in Bezug zu der Richtung der Magnetisierung des Wertdokuments an der Position der jeweiligen Sensorzeile gesetzt wird.

Zur Magnetisierung des Wertdokuments wird das Wertdokument entlang des Transportwegs nacheinander durch zwei Magnetisierungsabschnitte transportiert. Zunächst wird das Wertdokument durch einen ersten Magnetisierungsabschnitt transportiert, der zur Magnetisierung des Wertdokuments in eine erste Magnetisierungsrichtung ausgebildet ist, und danach durch einen zweiten Magnetisierungsabschnitt, der zur Magnetisierung des Wertdokuments in eine zweite Magnetisierungsrichtung ausgebildet ist und der nach dem ersten Magnetisierungsabschnitt angeordnet ist. In einigen Ausführungsbeispielen ist der zweite Magnetisierungsabschnitt unmittelbar nach dem ersten Magnetisierungsabschnitt angeordnet. Die Magnetfeldstärke des ersten Magnetisierungsabschnitts, die als erste Magnetfeldstärke bezeichnet wird, ist größer als die Magnetfeldstärke des zweiten Magnetisierungsabschnitts, die als zweite Magnetfeldstärke bezeichnet wird. Die erste Magnetfeldstärke ist vorzugsweise um mindestens einen Faktor 1,5, bevorzugt um mindestens einen Faktor 5, insbesondere um mindestens einen Faktor 10, größer als die zweite Magnetfeldstärke. Die erste Magnetisierungsrichtung ist vorzugsweise senkrecht zu der zweiten Magnetisierungsrichtung orientiert. Außerdem liegen die Magnetisierungsrichtungen des ersten und zweiten Magnetisierungsabschnitts bevorzugt in der Transportebene des Wertdokuments. Beispielsweise ist die erste Magnetisierungsrichtung parallel zur Transportrichtung des Wertdokuments und die zweite Magnetisierungsrichtung senkrecht zur Transportrichtung orientiert. Alternativ kann die erste Magnetisierungsrichtung senkrecht zur Transportrichtung des Wertdokuments und die zweite Magnetisierungsrichtung parallel zur Transportrichtung orientiert sein.

Bevorzugt ist zumindest die erste oder die zweite Hauptempfindlichkeitsrichtung parallel oder antiparallel zur ersten oder zur zweiten Magnetisierungsrichtung orientiert. In einigen Ausführungsbeispielen ist die erste Hauptempfindlichkeitsrichtung parallel oder antiparallel zur ersten oder zur zweiten Magnetisierungsrichtung orientiert und die zweite Hauptempfindlichkeitsrichtung ist parallel oder antiparallel zur anderen dieser Magnetisierungsrichtungen orientiert. D.h. die erste Hauptempfindlichkeitsrichtung ist parallel oder antiparallel zur ersten Magnetisierungsrichtung und die zweite Hauptempfindlichkeitsrichtung ist parallel oder antiparallel zu der zweiten Magnetisierungsrichtung orientiert oder umgekehrt. In anderen Ausführungsbeispielen ist die erste Hauptempfindlichkeitsrichtung parallel oder antiparallel zur ersten oder zweiten Magnetisierungsrichtung orientiert und die zweite Hauptempfindlichkeitsrichtung ist senkrecht zur ersten und senkrecht zur zweiten Magnetisierungsrichtung orientiert. Wie bereits oben erwähnt, ist die erste und zweite Magnetisierungsrichtung eine physikalische Eigenschaft des Wertdokuments. Die räumliche Lage der ersten und zweiten Magnetisierungsrichtung ist an der Position der Sensorzeilen daher durch die räumliche Lage des Wertdokuments definiert.

Beispielsweise ist die erste bzw. zweite Hauptempfindlichkeitsrichtung parallel zur Transportebene und senkrecht zur Transportrichtung orientiert, während die zweite bzw. erste Hauptempfindlichkeitsrichtung parallel zur Transportrichtung oder senkrecht zur Transportebene orientiert ist. Alternativ dazu kann die erste bzw. zweite Hauptempfindlichkeitsrichtung parallel zur Transportrichtung oder senkrecht zur Transportebene orientiert sein, während die zweite bzw. erste Hauptempfindlichkeitsrichtung parallel zur Transportebene und senkrecht zur Transportrichtung orientiert sein kann.

In einigen Ausführungsbeispielen weist der Magnetsensor, zusätzlich zur ersten und zweiten Sensorzeile, eine dritte Sensorzeile auf, die mehrere magnetosensitive Elemente mit einer dritten Hauptempfindlichkeitsrichtung aufweist. Die dritte Hauptempfindlichkeitsrichtung kann parallel zu der ersten oder parallel zu der zweiten Hauptempfindlichkeitsrichtung orientiert sein. Alternativ kann die dritte Hauptempfindlichkeitsrichtung auch senkrecht zur ersten und senkrecht zur zweiten Hauptempfindlichkeitsrichtung orientiert sein.

Des Weiteren kann die erfindungsgemäße Vorrichtung einen weiteren Magnetisierungsabschnitt aufweisen, der ein weiteres Magnetfeld zur Magnetisierung des Wertdokuments bereit stellt. Insbesondere wird der weitere Magnetisierungsabschnitt durch den Magnetsensor bereit gestellt. Der weitere Magnetisierungsabschnitt ist in unmittelbarer Nähe zur ersten, zur zweiten oder zur dritten Sensorzeile angeordnet und dazu ausgebildet, das vorbeitransportierte Wertdokument, zum Zeitpunkt der Detektion durch die jeweilige (erste, zweite oder dritte) Sensorzeile, zu magnetisieren. Beispielsweise sind in dem weiteren Magnetisierungsabschnitt nicht nur das vorbeitransportierte Wertdokument, sondern auch die magnetosensitiven Elemente der jeweiligen (ersten, zweiten oder dritten) Sensorzeile angeordnet. Die jeweilige (erste, zweite oder dritte) Sensorzeile kann die Magnetisierung des Wertdokuments daher unter dem Einfluss des weiteren Magnetfelds detektieren. Auf diese Weise kann die jeweilige (erste, zweite oder dritte) Sensorzeile auch magnetisches Material geringer Remanenz detektieren, wie z.B. weichmagnetisches Material des vorbeitransportierten Wertdokuments. Vorzugsweise ist die Magnetisierungsrichtung des weiteren Magnetisierungsabschnitts parallel zur ersten oder zur zweiten Magnetisierungsrichtung orientiert oder senkrecht zur ersten und zur zweiten Magnetisierungsrichtung orientiert.

Der weitere Magnetisierungsabschnitt ist beispielsweise in unmittelbarer Nähe zur dritten Sensorzeile angeordnet und dazu ausgebildet, das vorbeitransportierte Wertdokument, während der Detektion durch die dritte Sensorzeile, zu magnetisieren. Zur Magnetisierung des Wertdokuments wird dabei beispielsweise eine Magnetfeldstärke des weiteren Magnetisierungsabschnitts von mindestens 16 kA/ m verwendet. In einigen Ausführungsbeispielen werden als magnetosensitive Elemente der dritten Sensorzeile, die das Wertdokument unter dem Einfluss des weiteren Magnetfelds detektiert, magnetoresistive Elemente verwendet, die als GMR-, AMR-, TMR-, SdT- oder Spinventil-Elemente ausgebildet sind. In diesem Fall ist die Magnetisierungsrichtung des weiteren Magnetisierungsabschnitts vorzugsweise senkrecht zur Hauptempfindlichkeitsrichtung der magnetoresistiven Elemente der dritten Sensorzeile orientiert. In anderen Ausführungsbeispielen werden als magnetosensitive Elemente der dritten Sensorzeile, die das Wertdokument unter dem Einfluss des weiteren Magnetfelds detektiert, magnetoresistive Elemente verwendet, die als konventionelle Magnetowiderstandselemente ausgebildet sind. In diesem Fall ist die Magnetisierungsrichtung des weiteren Magnetisierungsabschnitts vorzugsweise parallel zur Hauptempfindlichkeitsrichtung der magnetoresistiven Elemente der dritten Sensorzeile, d.h. der konventionelle Magnetowiderstandselemente, orientiert. In diesen Ausführungsbeispielen wird durch das weitere Magnetfeld des weiteren Magnetisierungsabschnitts sowohl das Wertdokument magnetisiert als auch eine magnetische Vorspannung der konventionellen Magnetowiderstandselemente der dritten Sensorzeile parallel zu ihrer Hauptempfindlichkeitsrichtung erzeugt. Zur Magnetisierung des Wertdokuments und zur Vorspannung der konventionellen Magnetowiderstandselemente wird vorzugsweise eine Magnetfeldstärke des weiteren Magnetisierungsabschnitts von mindestens 16 kA/m verwendet.

In einem anderen Ausführungsbeispiel ist bereits die erste oder die zweite Sensorzeile in dem zweiten Magnetisierungsabschnitt angeordnet. Beispielsweise kann entlang der Transportstrecke zuerst eine Magnetisierungseinrichtung angeordnet sein, die den ersten Magnetisierungsabschnitt bereit stellt, und danach der Magnetsensor, in dem sowohl der zweite Magnetisierungsabschnitt als auch die beiden Sensorzeilen untergebracht sind. In dem zweiten Magnetisierungsabschnitt ist diejenige erste oder zweite Sensorzeile angeordnet, an der das Wertdokument entlang des Transportwegs zuerst vorbeitransportiert wird. Das Magnetfeld des zweiten Magnetisierungsabschnitts bewirkt eine Magnetisierung des vorbeitransportierten Wertdokuments, während das Wertdokument durch diese erste bzw. zweite Sensorzeile detektiert wird. Insbesondere weist diese erste bzw. zweite Sensorzeile magnetoresistive Elemente auf, die als GMR-, AMR-, TMR-, SdT- oder Spinventil-Elemente ausgebildet sind und deren Hauptempfindlichkeitsrichtung senkrecht zur zweiten Magnetisierungsrichtung des zweiten Magnetisierungsabschnitts orientiert ist.

Der erfindungsgemäße Magnetsensor und die erfindungsgemäße Vorrichtung können dazu verwendet werden, ein Wertdokument zu prüfen, das zwei Magnetmaterialien verschiedener Koerzitivfeldstärke enthält, insbesondere ein Wertdokument, das ein Sicherheitselement mit verschieden koerzitiven Magnetbereichen aufweist. Beispielsweise weist das Wertdokument, insbesondere das Sicherheitselement, zumindest einen ersten Magnetbereich mit einer ersten Koerzitivfeldstärke und zumindest einen zweiten Magnetbereich mit einer zweiten Koerzitivfeldstärke auf, wobei die erste Koerzitivfeldstärke größer ist als die zweite Koerzitivfeldstärke. Bevorzugt unterscheiden sich die erste und zweite Koerzitivfeldstärke um mindestens einen Faktor 1,5, vorzugsweise um mindestens einen Faktor 5, besonders bevorzugt um mindestens Faktor 10. Im Folgenden werden die ersten Magnetbereiche auch als hochkoerzitive Magnetbereiche und die zweiten Magnetbereiche als niederkoerzitive Magnetbereiche bezeichnet. In der vorliegenden Anmeldung wird mit den Begriffen hochkoerzitives bzw. niederkoerzitives Magnetmaterial stets hochkoerzitives bzw. niederkoerzitives Magnetmaterial bezeichnet, welches - ohne äußeres Magnetfeld - eine deutliche remanente Magnetisierung aufweist, die mit Magnetsensoren zur Wertdokumentprüfung üblicherweise detektiert werden kann. Insbesondere sind die genannten hochkoerzitiven bzw. niederkoerzitiven Magnetmaterialien hartmagnetische Magnetmaterialien mit relativ hoher bzw. relativ niedriger Koerzitivfeldstärke.

In einer speziellen Ausführungsform weisen der erste und zweite Magnetbereich etwa die gleiche remanente Magnetisierung auf. Die verschieden koerzitiven Magnetbereiche enthalten insbesondere verschiedene Magnetpigmente, z.B. verschiedene Eisenverbindungen, z.B. Eisenoxide, Magnetit oder Bariumferrit. Der oder die ersten und zweiten Magnetbereiche können auf dem Wertdokument, insbesondere auf dem Sicherheitselement, voneinander beabstandet angeordnet sein, sie können aber auch aneinander angrenzend, einander überlappend oder auch übereinander angeordnet sein. Die verschieden koerzitiven Magnetbereiche bilden beispielsweise zwei voneinander unabhängige magnetische Kodierungen. Außerdem kann das Wertdokument weichmagnetische Bereiche aufweisen, die z.B. mittels magnetischer Druckfarbe auf das Wertdokument aufgebracht sein können oder die in das Substrat des Wertdokuments eingebracht sind.

Zur Prüfung des Wertdokuments wird das Wertdokument entlang eines Transportwegs transportiert, insbesondere in einer Vorrichtung zur Wertdokumentbearbeitung, wobei folgende Schritte durchgeführt werden:
- Das Wertdokument wird zunächst durch einen ersten Magnetisierungsabschnitt mit einer ersten Magnetfeldstärke transportiert, die größer als die Koerzitivfeldstärken der beiden verschieden koerzitiven Magnetbereiche des Wertdokuments ist, also größer als die erste und als die zweite Koerzitivfeldstärke. Die erste Magnetisierungsrichtung des ersten Magnetisierungsabschnitts ist beliebig wählbar, liegt jedoch vorzugsweise in der Transportebene des Wertdokuments. Das Magnetfeld des ersten Magnetisierungsabschnitts magnetisiert sowohl die hochkoerzitiven als auch die niederkoerzitiven Magnetbereiche in die erste Magnetisierungsrichtung.
- Danach wird das Wertdokument durch einen zweiten Magnetisierungsabschnitt mit einer zweiten Magnetfeldstärke transportiert, die zwischen den Koerzitivfeldstärken der beiden verschieden koerzitiven Magnetbereichen liegt. Die zweite Magnetfeldstärke ist also kleiner als die erste Koerzitivfeldstärke, aber größer als die zweite Koerzitivfeldstärke. Die zweite Magnetisierungsrichtung des zweiten Magnetisierungsabschnitts ist senkrecht zu der ersten Magnetisierungsrichtung orientiert und liegt vorzugsweise ebenfalls in der Transportebene des Wertdokuments. Das Magnetfeld des zweiten Magnetisierungsabschnitts dreht nur die Magnetisierung der niederkoerzitiven Magnetbereiche von der ersten Magnetisierungsrichtung in die zweite Magnetisierungsrichtung, während die Magnetisierung der hochkoerzitiven Magnetbereiche durch das Magnetfeld des zweiten Magnetisierungsabschnitts nicht verändert wird, so dass die hochkoerzitiven Magnetbereiche in der ersten Magnetisierungsrichtung magnetisiert bleiben.
- Im weiteren Verlauf der Wertdokumentbearbeitung wird das Wertdokument an dem erfindungsgemäßen Magnetsensor vorbeitransportiert, der zur Detektion der Magnetisierung des Wertdokuments ausgebildet ist und der zumindest eine erste und eine zweite Sensorzeile mit verschiedenen, insbesondere senkrecht zueinander orientierten, Hauptempfindlichkeitsrichtungen aufweist. Die Detektion der Magnetisierung des Wertdokuments mit Hilfe des Magnetsensors kann unmittelbar nach der Magnetisierung des Wertdokuments oder später, im weiteren Verlauf der Wertdokumentbearbeitung erfolgen. Die Reihenfolge der ersten und zweiten Sensorzeile entlang des Transportwegs ist dabei beliebig wählbar.

Die erste Koerzitivfeldstärke beträgt beispielsweise mindestens 40 kA/m, die zweite Koerzitivfeldstärke beispielsweise mindestens 20 kA/m, wobei sie aber stets unterhalb der ersten Koerzitivfeldstärke liegt. Die erste Magnetfeldstärke des ersten Magnetisierungsabschnitts ist vorzugsweise mindestens Faktor 1,5 größer als die erste und als die zweite Koerzitivfeldstärke, d.h. mindestens 1,5 mal größer als die Koerzitivfeldstärken der hoch- und der niederkoerzitiven Magnetbereiche. Die zweite Magnetfeldstärke des zweiten Magnetisierungsabschnitts ist kleiner als die erste Koerzitivfeldstärke, d.h. als die Koerzitivfeldstärke der hochkoerzitiven Magnetbereiche, aber vorzugsweise mindestens Faktor 1,5 größer als die zweite Koerzitivfeldstärke, d.h. als die Koerzitivfeldstärke der niederkoerzitiven Magnetbereiche. Außerdem sind die erste und zweite Koerzitivfeldstärke so gewählt, dass diese, falls für die magnetoresistiven Elemente der ersten und zweiten Sensorzeile ein Vorspannungsmagnetfeld verwendet wird, größer sind als die Magnetfeldstärke dieses Vorspannungsmagnetfelds.

Die erste oder die zweite Sensorzeile detektiert selektiv die Magnetsignale der ersten Magnetbereiche mit der ersten Koerzitivfeldstärke (hochkoerzitive Magnetbereiche), die andere Sensorzeile, d.h. die zweite oder erste Sensorzeile, detektiert selektiv die Magnetsignale der zweiten Magnetbereiche mit der zweiten Koerzitivfeldstärke (niederkoerzitive Magnetbereiche). Die Magnetsignale der ersten und die Magnetsignale der zweiten Sensorzeile liefern Informationen über die Anordnung der hochkoerzitiven bzw. über die Anordnung die niederkoerzitiven Magnetbereiche auf dem Wertdokument, insbesondere auf dem Sicherheitselement. Da die hochkoerzitiven und niederkoerzitiven Magnetbereiche selektiv und damit unabhängig voneinander detektiert werden, können mit Hilfe der Erfindung zwei Magnetkodierungen aus verschieden koerzitiven Magnetbereichen, die auf demselben Wertdokument, insbesondere auf demselben Sicherheitselement, angeordnet sind, unabhängig voneinander ermittelt werden. Insbesondere können damit eine erste Magnetkodierung, die durch hochkoerzitive Magnetbereiche gebildet wird und eine zweite Magnetkodierung, die durch niederkoerzitive Magnetbereiche gebildet wird, unabhängig voneinander detektiert und erkannt werden. Aus den Magnetsignalen des Magnetsensors können also eine oder mehrere Magnetkodierungen des Wertdokuments ermittelt werden. Die Magnetkodierungen können insbesondere zur Bestimmung der Art des Wertdokuments, z.B. der Denomination, und/ oder der Echtheit des Wertdokuments vorgesehen sein.

Außerdem können durch den erfindungsgemäßen Magnetsensor auch kombinierte Magnetbereiche des Wertdokuments, die sowohl hoch- als auch niederkoerzitives Magnetmaterial aufweisen, erkannt und zuverlässig von den hoch- und niederkoerzitiven Magnetbereichen unterschieden werden. In dem kombinierten Magnetbereich können das hoch- und das niederkoerzitive Magnetmaterial beispielsweise gemischt enthalten sein. Alternativ können in dem kombinierten Magnetbereich hoch- und niederkoerzitive Magnetbereiche übereinander angeordnet sein. Diese kombinierten Magnetbereiche können von den übrigen Magnetbereichen, die entweder hochkoerzitives oder niederkoerzitives Magnetmaterial aufweisen, dadurch unterschieden werden, dass in diesem Fall die beiden miteinander korrespondierenden magnetosensitiven Elemente der jeweiligen Messspur Magnetsignale detektieren, während bei den einzelnen hoch- oder niederkoerzitiven Magnetbereichen jeweils nur eines der der beiden korrespondierenden magnetosensitiven Elemente der beiden Sensorzeilen Magnetsignale detektiert. Da die hochkoerzitiven und die niederkoerzitiven Magnetbereiche selektiv mit jeweils nur einer der Sensorzeilen detektiert werden und die kombinierten Magnetbereiche durch beide Sensorzeilen detektiert werden, können diese verschiedenen Magnetbereiche zuverlässig voneinander unterschieden werden. Mit Hilfe der Magnetsignale der ersten Sensorzeile und der zweiten Sensorzeile wird das Vorhandensein und/oder die Anordnung der ersten (hochkoerzitiven) Magnetbereiche und der zweiten (niederkoerzitiven) Magnetbereiche und gegebenenfalls der kombinierten Magnetbereiche auf dem Wertdokument geprüft.

Die Sensorzeilen weisen bevorzugt eine Vielzahl von Messspuren auf, mit denen die Anordnung der verschieden koerzitiven Magnetbereiche senkrecht zur Transportrichtung räumlich aufgelöst detektiert werden kann. Damit lässt sich beispielsweise eine quer zur Transportrichtung verlaufende magnetische Kodierung eines Sicherheitselement erkennen, wie z.B. die magnetische Kodierung eines Sicherheitsfadens im Fall einer Transportrichtung des Wertdokuments entlang seiner Längsrichtung. Die räumliche Auflösung liegt z.B. im Bereich eines oder mehrerer Millimeter. Die erfindungsgemäße Vorrichtung kann aber auch dazu verwendet werden, die Anordnung der verschieden koerzitiven Magnetbereiche auf dem Wertdokument parallel zur Transportrichtung zu detektieren. In diesem Fall erzeugen die verschieden koerzitiven Magnetbereiche an den Sensorzeilen zeitlich nacheinander Magnetsignale, aus denen, mit Hilfe der Transportgeschwindigkeit des Wertdokuments, die räumliche Anordnung der verschieden koerzitiven Magnetbereiche entlang der Transportrichtung bestimmt werden kann. Damit lässt sich beispielsweise eine parallel zur Transportrichtung verlaufende magnetische Kodierung eines Sicherheitselements, wie z.B. eines Sicherheitsfadens, erkennen, insbesondere wenn das Wertdokument entlang seiner kürzeren Seite transportiert wird.

Optional kann das Wertdokument, nach der Detektion der Magnetsignale durch die Sensorzeilen des Magnetsensors, ein Deaktivierungsmagnetfeld durchlaufen, durch welches die Magnetisierung der Magnetbereiche gelöscht oder nochmals verändert wird. Zu diesem Zweck kann in der Vorrichtung zur Wertdokumentbearbeitung nach den Sensorzeilen z.B. ein Entmagnetisierungseinrichtung vorgesehen sein, die das Wertdokument mit einem elektromagnetischen Wechselfeld beaufschlagt, oder ein Deaktivierungsmagnet großer Magnetfeldstärke, der die Magnetisierung aller Magnetbereiche des Wertdokuments in eine bestimmt Richtung ausrichtet.

Beispiele für das Sicherheitselement, das die verschieden koerzitiven Magnetbereiche enthält, sind ein Sicherheitselement, eine Planchette oder ein Etikett, die auf bzw. in das Wertdokument auf- bzw. eingebracht sind. Alternativ können die ersten und/ oder zweiten und/ oder kombinierten Magnetbereiche auch unabhängig von einem Sicherheitselement auf oder in dem Wertdokument enthalten sein, z.B. können die ersten und/oder zweiten und/oder kombinierten Magnetbereiche auf das Wertdokument aufgedruckt oder im Substrat des Wertdokuments enthalten sein.

Die Vorrichtung kann z.B. eine Sortiervorrichtung für Wertdokumente sein, oder auch eine Bezahlstation, ein Verkaufsautomat, eine Eingabevorrichtung, eine Ausgabevorrichtung oder eine Ein- und Ausgabevorrichtung für Wertdokumente, insbesondere eine Recyclingvorrichtung für Wertdokumente, etc..

Weitere Ausführungsformen und Vorteile der Erfindung werden im Folgenden anhand der Figuren sowie deren Beschreibung erläutert.

Es zeigen:
- Figur 1: Ein erstes Ausführungsbeispiel der Erfindung mit einer Magnetisierungseinrichtung, die räumlich getrennt von dem Magnetsensor angeordnet ist,
- Figuren 2a-c: schematische Darstellung dreier weiterer Ausführungsbeispiele in Draufsicht auf die Transportebene des Wertdokuments,
- Figuren 2d-e: schematische Darstellung eines weiteren Ausführungsbeispiels, magnetisch kodiertes Sicherheitselement und Tabelle zur Ermittlung der Magnetkodierung,
- Figur 3a-b: schematische Darstellung zweier weiterer Ausführungsbeispiele, bei denen zusätzlich eine dritte Sensorzeile verwendet wird,
- Figur 4: schematische Darstellung eines weiteren Ausführungsbeispiels mit einem zusätzlichen Magnetisierungsabschnitt im Detektionsbereich einer der beiden Sensorzeilen,
- Figur 5: schematische Darstellung eines weiteren Ausführungsbeispiels, bei dem der Detektionsbereich einer Sensorzeile im zweiten Magnetisierungsabschnitt liegt.

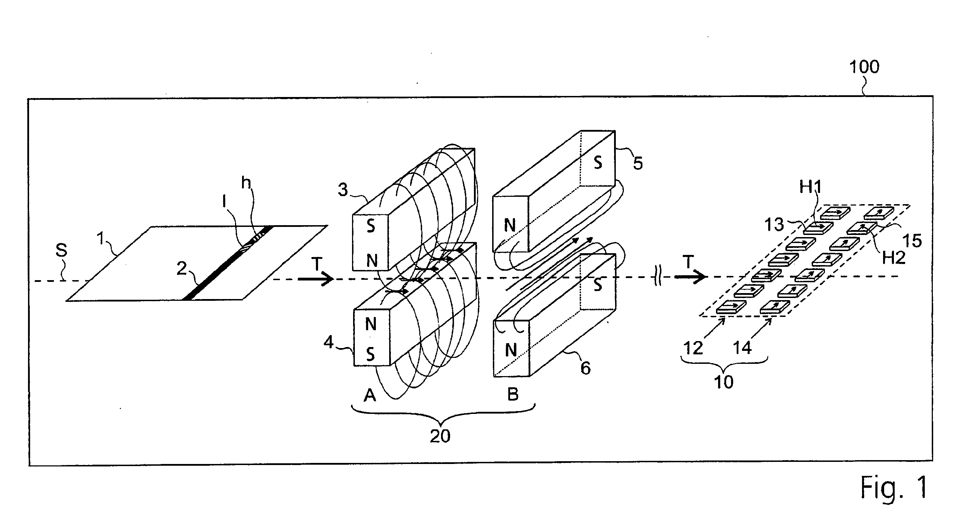

Figur 1 zeigt ein erstes Ausführungsbeispiel, bei dem ein Wertdokument 1 entlang eines Transportwegs S zuerst an einer Magnetisierungseinrichtung 20 mit zwei Magnetisierungsabschnitten A, B und danach an einem Magnetsensor 10 mit zwei Sensorzeilen 12,14 vorbei transportiert wird. Die Magnetisierungsabschnitte A, B werden bei diesem Ausführungsbeispiel jeweils durch zwei einander gegenüberliegende Magnete 3, 4 bzw. 5, 6 bereit gestellt, zwischen denen das Wertdokument 1 hindurch transportiert wird. Die Pole der Magnete 3, 4 sind so ausgerichtet, dass sich im Magnetisierungsabschnitt A ein Magnetfeld parallel zur Transportrichtung T ergibt. Zu Beginn des Magnetisierungsabschnitts A kann sich bei dieser Anordnung der Magnete 3, 4 ein antiparalleles Magnetfeld ausbilden, das zu einer vorausgehenden, zusätzlichen Ummagnetisierung des Wertdokuments führen kann, was jedoch auf die nach dem Magnetisierungsabschnitt A resultierende Magnetisierung keinen Einfluss hat. Die Pole der Magnete 5, 6 sind so ausgerichtet, dass sich im Magnetisierungsabschnitt B ein Magnetfeld senkrecht zur Transportrichtung T ergibt. Aufgrund des geringeren Abstands der Magnete 3, 4 im Vergleich zu den Magneten 5, 6 ist die Magnetfeldstärke des Magnetisierungsabschnitts A größer als die Magnetfeldstärke des Magnetisierungsabschnitts B, beispielsweise um mindestens einen Faktor 1,5. Alternativ können die Abstände der Magnete 3, 4 und der Magnete 5, 6 auch gleich groß gewählt sein und die Stärke der Magnete 3, 4 und 5, 6 entsprechend der jeweils gewünschten Magnetfeldstärke der Magnetisierungsabschnitte A, B gewählt werden. Die Magnetfelder der Magnetisierungsabschnitte A, B können alternativ natürlich auch mit Hilfe andersartiger Magnete oder mit Hilfe von stromdurchflossenen elektrischen Leitern erzeugt werden. An Stelle zweier gegenüberliegender Magnete kann zur Bereitstellung eines Magnetisierungsabschnitts z.B. auch ein einzelner Magnet verwendet werden, der nur auf einer Seite des vorbeitransportierten Wertdokuments 1 angeordnet ist. Die gezeigte Anordnung ist in einer Vorrichtung 100 zur Wertdokumentbearbeitung enthalten, in die die Wertdokumente 1 einzeln oder stapelweise eingegeben werden, anschließend geprüft, sortiert und in der Vorrichtung 100 abgespeichert oder wieder ausgegeben werden. Das in Figur 1 gezeigte Wertdokument 1 weist ein Sicherheitselement 2 mit einer Magnetkodierung auf, die durch Magnetbereiche eines hochkoerzitiven Magnetmaterials und Magnetbereiche eines niederkoerzitiven Magnetmaterials gebildet wird. Beispielhaft ist in Figur 1 jeweils nur ein hochkoerzitiver Magnetbereich h und ein niederkoerzitiver Magnetbereich 1 dargestellt.

Der erste Magnetisierungsabschnitt A weist ein parallel zur Transportrichtung T des Wertdokuments 1 orientiertes Magnetfeld mit großer Magnetfeldstärke auf, die so gewählt ist, dass sie größer als die Koerzitivfeldstärken beider magnetischer Materialien des Sicherheitselements 2 ist. Durch den ersten Magnetisierungsabschnitt A werden sowohl die hochkoerzitiven Magnetbereiche als auch die niederkoerzitiven Magnetbereiche des Sicherheitselements 2 magnetisiert, wobei die (erste) Magnetisierungsrichtung parallel zur Transportrichtung T des Wertdokuments 1 orientiert ist. Der zweite Magnetisierungsabschnitt B der Magnetisierungseinrichtung 20 weist eine senkrecht zur Transportrichtung T des Wertdokuments 1 orientiertes Magnetfeld mit geringerer Magnetfeldstärke auf, die so gewählt ist, dass sie zwischen den Koerzitivfeldstärken der beiden magnetischen Materialien des Sicherheitselements 2 liegt. Das Magnetfeld des zweiten Magnetisierungsabschnitts B magnetisiert nur die niederkoerzitiven Magnetbereiche um, und zwar in eine (zweite) Magnetisierungsrichtung senkrecht zur Transportrichtung T, während die Magnetisierung der hochkoerzitiven Magnetbereiche parallel zur Transportrichtung orientiert bleibt.

Im weiteren Verlauf der Wertdokumentbearbeitung in der Vorrichtung 100 wird das Wertdokument 1 an dem Magnetsensor 10 vorbeitransportiert, der in diesem Ausführungsbeispiel räumlich getrennt von der Magnetisierungseinrichtung 20 in der Vorrichtung 100 eingebaut ist. Dazwischen können z.B. Verzweigungen oder Umlenkungen des Transportwegs S vorgesehen sein. Der Magnetsensor 10 enthält zwei Sensorzeilen 12,14, die jeweils eine Vielzahl gleichartiger magnetosensitiver Elemente 13, 15 aufweisen, die in einer Zeile angeordnet sind. In diesem Beispiel sind die magnetosensitiven Elemente als magnetoresistive Elemente 13, 15 ausgebildet, es können stattdessen aber auch induktive Elemente, Hallelemente etc. verwendet werden. Die Sensorzeilen 12,14 sind in unmittelbarer Nähe zur Transportebene des Wertdokuments 1 angeordnet. Es kann vorgesehen sein, dass die vorbeitransportierten Wertdokumente 1 die Oberfläche der Sensorzeilen 12,14 berühren, es kann aber auch ein geringer Abstand zwischen der Oberfläche der Sensorzeilen 12,14 und dem vorbeitransportierten Wertdokument 1 vorgesehen sein, z.B. ein Abstand im mm-Bereich. Die magnetoresistiven Elemente 13 der ersten Sensorzeile 12 weisen eine Hauptempfindlichkeitsrichtung H1 auf, die parallel zur Transportrichtung T und damit parallel zur Magnetisierungsrichtung des Magnetisierungsabschnitts A orientiert ist, während die magnetoresistiven Elemente 15 der zweiten Sensorzeile 14 eine Hauptempfindlichkeitsrichtung H2 aufweisen, die senkrecht zur Transportrichtung T und damit parallel zur Magnetisierungsrichtung des Magnetisierungsabschnitts B orientiert ist. Die Hauptempfindlichkeitsrichtungen H1 und H2 sind in Figur 1 durch Pfeile auf den jeweiligen magnetoresistiven Elementen 13 bzw. 15 eingezeichnet. Entlang des Transportwegs S kann die erste Sensorzeile 12, wie in Figur 1 gezeigt, vor der zweiten Sensorzeile 14 angeordnet sein, alternativ kann die erste Sensorzeile 12 aber auch nach der zweiten Sensorzeile 14 angeordnet sein.

Das Sicherheitselement 2 des Wertdokuments 1, das auf die oben beschriebene Weise durch die Magnetisierungseinrichtung 20 magnetisiert wurde, wird anschließend an den beiden Sensorzeilen 12,14 vorbeitransportiert, die Magnetsignale aufnehmen, um die Magnetisierung des Sicherheitselements 2 zu detektieren. Die magnetoresistiven Elemente 13, deren Hauptempfindlichkeitsrichtung H1 parallel zum Magnetfeld des Magnetisierungsabschnitts A orientiert ist, detektieren Magnetsignale der parallel zu H1 magnetisierten hochkoerzitiven Magnetbereiche h. Die niederkoerzitiven Magnetbereiche 1, die senkrecht zu H1 magnetisiert sind, erzeugen an den magnetoresistiven Elementen 13 nur ein vernachlässigbar geringes Magnetsignal. Die magnetoresistiven Elemente 15, deren Hauptempfindlichkeitsrichtung H2 parallel zum Magnetfeld des Magnetisierungsabschnitts B orientiert ist, detektieren Magnetsignale der parallel zu H2 magnetisierten niederkoerzitiven Magnetbereiche 1. Die hochkoerzitiven Magnetbereiche h, die senkrecht zu H2 magnetisiert sind, erzeugen an den magnetoresistiven Elementen 15 nur ein vernachlässigbar geringes Magnetsignal. Mit der ersten Sensorzeile 12 werden also selektiv die Magnetsignale der hochkoerzitiven Magnetbereiche detektiert und mit der zweiten Sensorzeile 14 werden selektiv die Magnetsignale der niederkoerzitiven Magnetbereiche detektiert. Mit Hilfe der Magnetsignale der ersten Sensorzeile 12 kann die Anordnung der hochkoerzitiven Magnetbereiche auf dem Sicherheitselement 2 ermittelt werden und, unabhängig davon, mit Hilfe der Magnetsignale der zweiten Sensorzeile 14 die Anordnung die niederkoerzitiven Magnetbereiche auf dem Sicherheitselement 2.

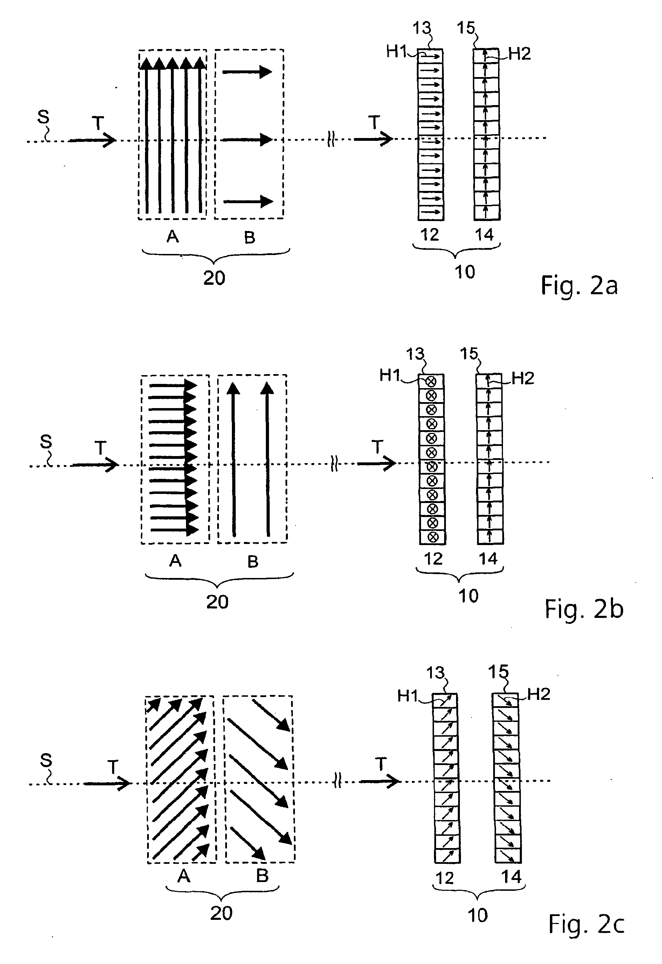

In den Figuren 2a-c sind drei weitere Ausführungsbeispiele gezeigt, wobei jeweils schematisch die Magnetisierungsabschnitte A und B der Magnetisierungseinrichtung 20 und die beiden Sensorzeilen 12 und 14 des Magnetsensors 10 in Draufsicht auf die Transportebene des Wertdokuments 1 dargestellt sind und deren Lage in Bezug auf den Transportweg S. Entlang des Transportwegs S wird ein Wertdokument 1 transportiert, das jeweils einen oder mehrere hochkoerzitive und niederkoerzitive Magnetbereiche aufweist, die auf dem Wertdokument 1 z.B. nebeneinander und/oder übereinander angeordnet sein können. Von den Magnetisierungsabschnitten A, B ist jeweils nur der in der Transportebene des Wertdokuments 1 liegende Ausschnitt gezeigt, wobei die jeweilige Magnetisierungsrichtung und die jeweilige Magnetfeldstärke anhand von Magnetfeldlinien verdeutlicht ist. Dabei zeigt eine höhere Dichte der eingezeichneten Magnetfeldlinien qualitativ eine größere Magnetfeldstärke an. Die in den Figuren 2a-c gewählte Darstellungsweise wird analog auch für die folgenden Ausführungsbeispiele verwendet.

In dem Ausführungsbeispiel der Figur 2a ist die Hauptempfindlichkeitsrichtung H1 der magnetoresistiven Elemente 13 der ersten Sensorzeile 12, wie beim Ausführungsbeispiel aus Figur 1, parallel zur Transportrichtung T orientiert und die Hauptempfindlichkeitsrichtung H2 der magnetoresistiven Elemente 15 der zweiten Sensorzeile 14 senkrecht zur Transportrichtung T, aber parallel zur Transportebene des Wertdokuments 1. Die Magnetisierungsrichtungen der beiden Magnetisierungsabschnitte A, B sind umgekehrt zu denen aus Figur 1. Der erste Magnetisierungsabschnitt A, dessen Magnetfeldstärke wiederum größer als die Koerzitivfeldstärken der hochkoerzitiven Magnetbereiche und der niederkoerzitiven Magnetbereiche ist, magnetisiert die hoch- und niederkoerzitiven in eine Magnetisierungsrichtung senkrecht zur Transportrichtung T, aber parallel zur Transportebene. Der zweite Magnetisierungsabschnitt B, dessen Magnetfeldstärke zwischen den beiden Koerzitivfeldstärken liegt, magnetisiert die niederkoerzitiven Magnetbereiche in eine Magnetisierungsrichtung parallel zur Transportrichtung T. Von einem entsprechend Figur 2a magnetisierten Wertdokument 1 detektieren die magnetoresistiven Elemente 13 der ersten Sensorzeile 12 selektiv die niederkoerzitiven Magnetbereiche, während die magnetoresistiven Elemente 15 der zweiten Sensorzeile 14 selektiv die hochkoerzitiven Magnetbereiche detektieren. Die Reihenfolge der beiden Sensorzeilen 12,14 entlang des Transportwegs S ist beliebig vertauschbar.

An Stelle der magnetoresistiven Elemente mit Hauptempfindlichkeitsrichtung parallel zur Transportrichtung T können alternativ magnetoresistive Elemente mit einer Hauptempfindlichkeitsrichtung verwendet werden, die senkrecht zur Transportebene des Wertdokuments 1 orientiert ist. Da die Magnetisierung eines Magnetbereichs auch zu einem magnetischen Feld in der unmittelbaren Umgebung des jeweiligen Magnetbereichs führt, lässt sich die Magnetisierung eines parallel zur Transportrichtung T magnetisierten Magnetbereichs auch anhand des durch ihn in seiner unmittelbaren Umgebung, senkrecht zur Transportebene verursachten Magnetfelds detektieren. Ausgehend von dem Ausführungsbeispiel aus Figur 2a kann die Sensorzeile 12 daher alternativ magnetoresistive Elemente 13 aufweisen, deren Hauptempfindlichkeitsrichtung senkrecht zur Transportebene orientiert ist, so wie es in dem Ausführungsbeispiel aus Figur 2b gezeigt ist. Auch bei diesem Ausführungsbeispiel sind sowohl die Reihenfolge der beiden Sensorzeilen 12,14 entlang des Transportwegs S beliebig vertauschbar als auch die Magnetisierungsrichtungen der Magnetisierungsabschnitte A und B. Auch in diesem Fall detektieren die magnetoresistiven Elemente 13 der ersten Sensorzeile 12 von einem entsprechend Figur 2b magnetisierten Sicherheitselement 2, selektiv die hochkoerzitiven Magnetbereiche, während die magnetoresistiven Elemente 15 der zweiten Sensorzeile 14 selektiv die niederkoerzitiven Magnetbereiche detektieren.

In dem Ausführungsbeispiel der Figur 2c verlaufen sowohl die Magnetisierungsrichtungen der Magnetisierungsabschnitte A und B als auch die Hauptempfindlichkeitsrichtungen H1, H2 der magnetoresistiven Elemente 13,15 der Sensorzeilen 12,14 schräg zur Transportrichtung T. Die Magnetisierungsrichtung des ersten Magnetisierungsabschnitts A, dessen Magnetfeldstärke wiederum größer als die Koerzitivfeldstärken der hochkoerzitiven Magnetbereiche und der niederkoerzitiven Magnetbereiche ist, ist parallel zur Hauptempfindlichkeitsrichtung H1 der magnetoresistiven Elemente 13 der ersten Sensorzeile 12 orientiert. Die Magnetisierungsrichtung des zweiten Magnetisierungsabschnitts B ist so gewählt, dass sie senkrecht zur Magnetisierungsrichtung des ersten Magnetisierungsabschnitt A verläuft, wobei die Magnetfeldstärke des zweiten Magnetisierungsabschnitts B wiederum zwischen den beiden Koerzitivfeldstärken liegt. Die Hauptempfindlichkeitsrichtung H2 der magnetoresistiven Elemente 15 der zweiten Sensorzeile 14 ist so gewählt, dass sie parallel zur Magnetisierungsrichtung des zweiten Magnetisierungsabschnitts B orientiert ist, und damit senkrecht zur Hauptempfindlichkeitsrichtung H1. Die magnetoresistiven Elemente 13 der ersten Sensorzeile 12 detektieren selektiv die hochkoerzitiven Magnetbereiche, während die magnetoresistiven Elemente 15 der zweiten Sensorzeile 14 selektiv die niederkoerzitiven Magnetbereiche detektieren. Der Winkel, den das Magnetfeld eines der beiden Magnetisierungsabschnitte A, B mit der Transportrichtung T des Wertdokuments 1 einschließt, kann beliebig gewählt werden. Der Winkel des Magnetfelds des anderen der beiden Magnetisierungsabschnitte A, B wird senkrecht dazu gewählt, wobei beide Magnetisierungsrichtungen vorzugsweise in der Transportebene des Wertdokuments 1 liegen. Auch bei diesem Ausführungsbeispiel ist die Reihenfolge der beiden Sensorzeilen 12,14 entlang des Transportwegs S beliebig vertauschbar.

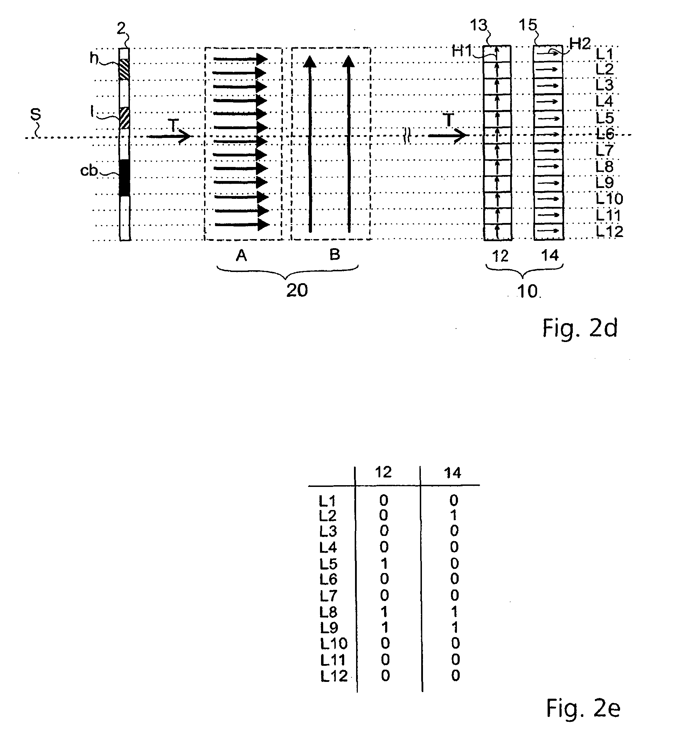

In dem Ausführungsbeispiel der Figur 2d stellen der erste und zweite Magnetisierungsabschnitt A, B Magnetfelder analog zum Ausführungsbeispiel der Figur 1 bereit. Anders als in Figur 1 verläuft die Hauptempfindlichkeitsrichtung H1 der magnetoresistiven Elemente 13 der ersten Sensorzeile 12 in diesem Ausführungsbeispiel senkrecht zur Transportrichtung T und die Hauptempfindlichkeitsrichtung H2 der magnetoresistiven Elemente 15 der zweiten Sensorzeile 14 parallel zur Transportrichtung T. Die magnetoresistiven Elemente 13 der ersten Sensorzeile 12 detektieren selektiv die niederkoerzitiven Magnetbereiche, während die magnetoresistiven Elemente 15 der zweiten Sensorzeile 14 selektiv die hochkoerzitiven Magnetbereiche detektieren. Insgesamt sind bei dem gezeigten Magnetsensor 10 zwölf Messspuren L1-L12 vorgesehen, für die in jeder der beiden Sensorzeilen 12, 14 jeweils ein magnetoresistives Element 13, 15 zur Verfügung steht. In dem gezeigten Beispiel wird ein Wertdokument 1 mit einem Sicherheitselement 2 geprüft, das einen einzelnen hochkoerzitiven Magnetbereiche h, einen einzelnen niederkoerzitiven Magnetbereich 1 und einen kombinierten Magnetbereich cb enthält, in dem ein hochkoerzitiver Magnetbereich h und ein niederkoerzitiver Magnetbereich 1 im selben Bereich auf dem Sicherheitselement 2 angeordnet sind. In dem kombinierten Magnetbereich können der hochkoerzitive und der niederkoerzitive Magnetbereich z.B. übereinander angeordnet sein oder es kann eine Mischung der verschieden koerzitiven Magnetmaterialien darin enthalten sein. Von diesem Sicherheitselement 2 detektieren von der Sensorzeile 12 nur die magnetoresistiven Elemente 13 der Messspuren L5, L8 und L9 ein Magnetsignal, das über einem vorgegebenen Schwellenwert liegt. Von der zweiten Sensorzeile 14 detektieren nur die magnetoresistiven Elemente 15 der Messspuren L2, L8 und L9 ein Magnetsignal, das über einem vorgegebenen Schwellenwert liegt.

In Figur 2e ist eine Tabelle mit den Ergebnissen einer Signalauswertung gezeigt, der die Magnetsignale der einzelnen Messspuren L1-L12 der Sensorzeilen 12,14 unterzogen wurden. Dabei repräsentiert "0" ein Magnetsignal, das unterhalb des vorgegebenen Schwellenwerts liegt und "1" ein Magnetsignal, das den vorgegebenen Schwellenwert erreicht oder überschreitet. Alternativ zum Vergleich mit vorgegebenen Schwellenwerten können die Magnetsignale natürlich auch mit Hilfe anderer Auswerteverfahren verarbeitet werden. In der Messspur L2 zeigt nur das magnetoresistive Element 13 der ersten Sensorzeile 12 das Vorhandensein eines (h-)Magnetbereichs an (Signatur "0, 1"). In der Messspur L5 zeigt nur das magnetoresistive Element 15 der zweiten Sensorzeile 14 das Vorhandensein eines (1-)Magnetbereichs an (Signatur "1, 0"). Dagegen zeigen in den Messspuren L8 und L9 jeweils die korrespondierenden magnetoresistiven Elemente 13, 15 beider Sensorzeilen 12,14 das Vorhandensein eines h- bzw.1-Magnetbereichs an. Die Messspuren L8 und L9 weisen also eine Signatur "1, 1" auf, die das Vorhandensein eines kombinierten Magnetbereichs cb anzeigt, der sowohl hochkoerzitives als auch niederkoerzitives Magnetmaterial enthält.

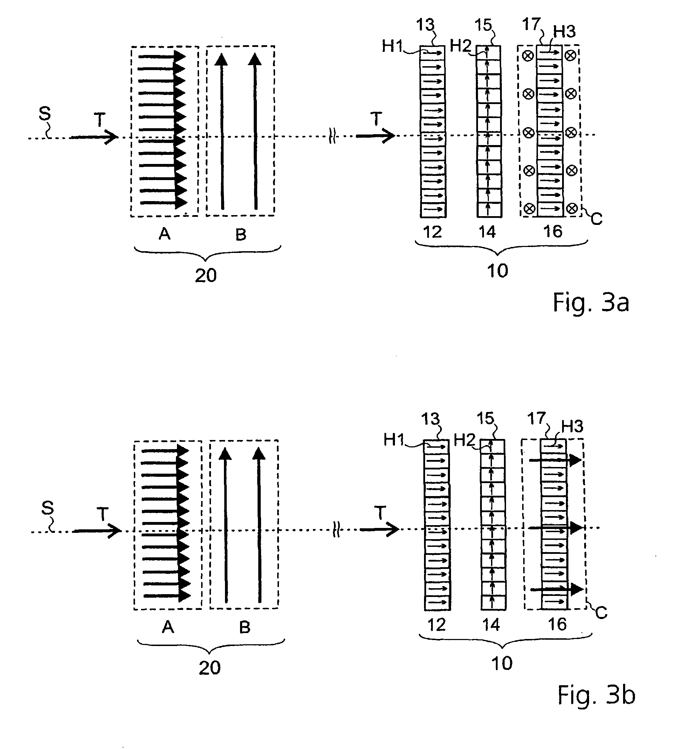

Bei dem Ausführungsbeispiel aus Figur 3a weist der Magnetsensor 10, außer den beiden Sensorzeilen 12,14, zusätzlich eine dritte Sensorzeile 16 mit mehreren magnetoresistiven Elementen 17 einer dritten Hauptempfindlichkeitsrichtung H3 auf, die in dem gezeigten Beispiel parallel zur Hauptempfindlichkeitsrichtung H1 der magnetoresistiven Elemente 13 der ersten Sensorzeile 12 orientiert ist. Die dritte Sensorzeile 16 ist in einem weiteren Magnetisierungsabschnitt C angeordnet, der das vorbeitransportierte Wertdokument 1 zum Zeitpunkt der Detektion durch die Sensorzeile 16 magnetisiert. Die Magnetisierungsrichtung des dritten Magnetisierungsabschnitts C ist senkrecht zur Hauptempfindlichkeitsrichtung der magnetoresistiven Elemente 17 orientiert, die als GMR-, AMR-, TMR-, SdT- oder Spinventil-Elemente ausgebildet sind. Der weitere Magnetisierungsabschnitt C kann z.B. durch einen weiteren Magneten oder durch einen stromdurchflossenen Leiter erzeugt werden, der in unmittelbarer Nähe zur Sensorzeile 16 angeordnet ist. Die Sensorzeilen 12,14 liegen außerhalb des weiteren Magnetisierungsabschnitts C. Bei dem in Figur 3a gezeigten Beispiel ist die Magnetisierungsrichtung des weiteren Magnetisierungsabschnitts C senkrecht zur den Magnetisierungsrichtungen der Magnetisierungsabschnitte A und B orientiert. Da das Wertdokument 1, während der Detektion durch die Sensorzeile 16, dem Magnetfeld des weiteren Magnetisierungsabschnitts C ausgesetzt ist, ermöglicht der weitere Magnetisierungsabschnitt C, dass mit Hilfe der dritten Sensorzeile auch magnetisches Material geringer Remanenz detektiert werden kann, z.B. weichmagnetisches Material. Der Magnetsensor 10 aus Figur 3 kann daher vorteilhaft sowohl permanent magnetisierte, z.B. hartmagnetische, Materialien, detektieren (mit Hilfe der Sensorzeilen 12,14 und 16) als auch Materialien geringer Remanenz, wie z.B. weichmagnetisches Material (mit Hilfe der Sensorzeile 16). Zur Magnetisierung des weichmagnetischen Materials wird für den dritten Magnetisierungsabschnitt C beispielsweise eine weitere Magnetfeldstärke von mindestens 16 kA/m verwendet. Ausgehend von Figur 3a kann alternativ die dritte Hauptempfindlichkeitsrichtung H3 der magnetoresistiven Elemente 17 der Sensorzeile 16 senkrecht zur Transportebene gewählt werden und die weitere Magnetisierungsrichtung des weiteren Magnetisierungsabschnitts C parallel zur Transportrichtung T, so dass die weitere Magnetisierungsrichtung parallel zur ersten Magnetisierungsrichtung des ersten Magnetisierungsabschnitts A orientiert ist.

Figur 3b zeigt ein weiteres Ausführungsbeispiel, bei dem, im Unterschied zu dem in Figur 3a dargestellten Ausführungsbeispiel, die dritte Sensorzeile 16 konventionelle Magnetowiderstandselemente 17 aufweist, die auf Basis des allgemeinen Magnetowiderstands funktionieren. Die Sensorzeilen 13,15 können z.B. GMR-, AMR-, TMR-, SdT- oder Spinventil-Elemente aufweisen. Die Magnetisierungsrichtung des weiteren Magnetisierungsabschnitts C wird bei konventionellen Magnetowiderstandselementen 17 bevorzugt parallel zu deren Hauptempfindlichkeitsrichtung H3 gewählt. In dem gezeigten Beispiel ist die Magnetisierungsrichtung des weiteren Magnetisierungsabschnitts C parallel zur Transportrichtung T orientiert. Alternativ können die Magnetisierungsrichtung des weiteren Magnetisierungsabschnitts C und die dritte Hauptempfindlichkeitsrichtung H3 der magnetoresistiven Elemente 17 auch senkrecht zur Transportebene gewählt werden. Bei allen zu den Figuren 3a, 3b genannten Ausführungsbeispielen kann die Hauptempfindlichkeitsrichtung H1 der magnetoresistiven Elemente 13 alternativ senkrecht zur Transportebene gewählt werden. Außerdem ist bei all diesen Ausführungsbeispielen auch die Reihenfolge der Sensorzeilen 12,14,16 entlang des Transportwegs S beliebig und die Magnetisierungsrichtungen der Magnetisierungsabschnitte A und B können vertauscht sein. Für den weiteren Magnetisierungsabschnitt C wird beispielsweise eine weitere Magnetfeldstärke von mindestens 16 kA/m verwendet, durch die das weichmagnetische Material magnetisiert und die konventionellen Magnetowiderstandselemente magnetisch vorgespannt werden.

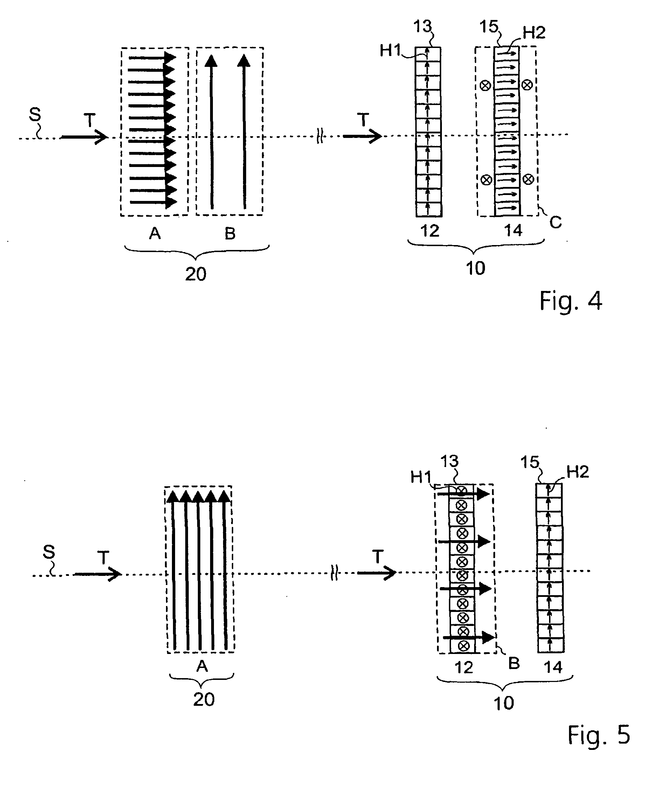

Im Unterschied zu den Ausführungsbeispielen der Figuren 2a-d und 3a-b ist beim Ausführungsbeispiel der Figur 4 nun in unmittelbarer Nähe zur zweiten Sensorzeile 14 ein weiterer Magnetisierungsabschnitt C vorgesehen, der das vorbeitransportierte Wertdokument 1, zum Zeitpunkt der Detektion durch die zweite Sensorzeile 14, magnetisiert. Die Magnetisierungsrichtung des weiteren Magnetisierungsabschnitts C ist in diesem Beispiel senkrecht zur Transportebene, und damit auch senkrecht zur Hauptempfindlichkeitsrichtung H2 der magnetoresistiven Elemente 15 orientiert, die in diesem Beispiel als GMR-, AMR-, TMR-, SdT- oder Spinventil-Elemente ausgebildet sind. Analog zu den vorangegangenen Beispielen weist die Sensorzeile 12 selektiv niederkoerzitive Magnetbereiche nach, während die Sensorzeile 14 selektiv hochkoerzitive Magnetbereiche nachweist. Das Magnetfeld des dritten Magnetisierungsabschnitts C führt außerdem zur Magnetisierung von weichmagnetischem Magnetmaterial, das auf bzw. in dem vorbeitransportierten Wertdokument 1 enthalten sein kann. Mit Hilfe der Sensorzeile 14 kann daher auch die Magnetisierung von weichmagnetischem Material des Wertdokuments 1 im Magnetfeld detektiert werden. Die Sensorzeile 14 liefert also sowohl Magnetsignale der hartmagnetischen, hochkoerzitiven Magnetbereiche als auch Magnetsignale von weichmagnetischem Magnetmaterial, soweit das jeweilige Wertdokument 1 solches aufweist. Falls das Wertdokument hart- und weichmagnetische Magnetmaterialien aufweist, so sind diese jedoch üblicherweise in verschiedenen Bereichen des Wertdokuments 1 angeordnet, so z.B. hartmagnetisches Material in einem Sicherheitsfaden und weichmagnetisches Material in der Druckfarbe. Die Magnetsignale der Sensorzeile 14 können dann anhand ihres jeweiligen Detektionsorts auf dem Wertdokument dem hart- bzw. dem weichmagnetischen Magnetmaterial zugeordnet werden.

Im Beispiel der Figur 4 ist die weitere Magnetfeldstärke des weiteren Magnetisierungsabschnitts C so gewählt, dass sie unterhalb der Koerzitivfeldstärke der niederkoerzitiven Magnetbereiche des Wertdokuments 1 liegt. Daher bewirkt der Magnetisierungsabschnitt C in diesem Beispiel keine Ummagnetisierung der niederkoerzitiven Magnetbereiche. Alternativ zu Figur 4 kann die Hauptempfindlichkeitsrichtung der zweiten Sensorzeile 14 auch senkrecht zur Transportebene orientiert sein und die Magnetisierungsrichtung des dritten Magnetisierungsabschnitts C, in dem die zweite Sensorzeile angeordnet ist, parallel zur Transportrichtung T orientiert sein. Auch bei den zu Figuren 4 genannten Ausführungsbeispielen kann die Reihenfolge der Sensorzeilen 12 und 14 entlang des Transportwegs S beliebig gewählt werden und die Magnetisierungsrichtungen der Magnetisierungsabschnitte A und B können miteinander vertauscht sein.

Bei dem Ausführungsbeispiel der Figur 5 stellt die Magnetisierungseinrichtung 20 nur den ersten Magnetisierungsabschnitt A bereit, während der zweite Magnetisierungsabschnitt B erst im Magnetsensor 10, im Bereich der ersten Sensorzeile 12 bereit gestellt wird, die in dem zweiten Magnetisierungsabschnitt B angeordnet ist. Der zweite Magnetisierungsabschnitt B bewirkt eine Magnetisierung des vorbeitransportierten Wertdokuments 1. Die Magnetisierung der niederkoerzitiven Magnetbereiche, die durch den ersten Magnetisierungsabschnitt A ausgerichtet wurden, wird durch den zweiten Magnetisierungsabschnitt B parallel zur Transportrichtung T ausgerichtet. Die Drehung der Magnetisierung erfolgt dabei auf einer relativ kurzen Zeitskala, so dass die niederkoerzitiven Magnetbereiche zum Zeitpunkt ihrer Detektion durch die erste Serisorzeile 12 bereits im Wesentlichen ummagnetisiert sind. Die erste Sensorzeile 12 detektiert daher selektiv die niederkoerzitiven Magnetbereiche, während die zweite Sensorzeile 14 selektiv die hochkoerzitiven Magnetbereich detektiert, deren Magnetisierung durch das Magnetfeld des zweiten Magnetisierungsabschnitts B unverändert bleibt. Das Magnetfeld des zweiten Magnetisierungsabschnitts B führt außerdem zur Magnetisierung von weichmagnetischem Magnetmaterial, das auf bzw. in dem vorbeitransportierten Wertdokument 1 enthalten sein kann. Mit Hilfe der Sensorzeile 12 kann daher auch die Magnetisierung von weichmagnetischem Material des Wertdokuments 1 im Magnetfeld detektiert werden.

## Patentansprüche

1. Vorrichtung (100) zur Prüfung eines Wertdokuments (1) mit
- einem Transportsystem zum Transportieren des Wertdokuments (1) in eine Transportrichtung (T) entlang eines Transportwegs (S), wobei das Wertdokument (1) eine Transportebene aufspannt, und
- einem ersten Magnetisierungsabschnitt (A) zur Magnetisierung des Wertdokuments (1) in eine erste Magnetisierungsrichtung und einem zweiten Magnetisierungsabschnitt (B) zur Magnetisierung des Wertdokuments (1) in eine zweite Magnetisierungsrichtung, wobei der zweite Magnetisierungsabschnitt (B) entlang des Transportwegs (S) nach dem ersten Magnetisierungsabschnitt (A) angeordnet ist, und
- einem Magnetsensor (10)
**dadurch gekennzeichnet, dass**
- der Magnetsensor eine erste Sensorzeile (12) aufweist, die mehrere magnetosensitive Elemente (13) mit einer ersten Hauptempfindlichkeitsrichtung (H1) aufweist, und der eine zweite Sensorzeile (14) aufweist, die mehrere magnetosensitive Elemente (15) mit einer zweiten Hauptempfindlichkeitsrichtung (H2) aufweist, die von der ersten Hauptempfindlichkeitsrichtung (H1) verschieden ist, und ggf. eine dritte Sensorzeile aufweist, und
- dass die Vorrichtung, insbesondere der Magnetsensor (10), einen weiteren Magnetisierungsabschnitt (C) aufweist, der zur Magnetisierung des Wertdokuments (1) in eine weitere Magnetisierungsrichtung ausgebildet ist, wobei der weitere Magnetisierungsabschnitt (C) dazu ausgebildet ist, das Wertdokument (1), während der Detektion des Wertdokuments (1) durch die erste (12), durch die zweite (14) oder durch die dritte Sensorzeile (16), zu magnetisieren.

2. Vorrichtung (100) nach Anspruch 1, **dadurch gekennzeichnet, dass** die erste Hauptempfindlichkeitsrichtung (H1) im Wesentlichen senkrecht zu der zweiten Hauptempfindlichkeitsrichtung (H2) orientiert ist.

3. Vorrichtung (100) nach einem der vorhergehenden Ansprüche, **dadurch gekennzeichnet, dass** der Magnetsensor (10) eine dritte Sensorzeile (16) aufweist, die mehrere magnetosensitive, insbesondere magnetoresistive, Elemente (17) mit einer dritten Hauptempfindlichkeitsrichtung (H3) aufweist.

4. Vorrichtung (100) nach Anspruch 3, **dadurch gekennzeichnet, dass** die dritte Hauptempfindlichkeitsrichtung (H3) insbesondere entweder im Wesentlichen parallel zur ersten oder zur zweiten Hauptempfindlichkeitsrichtung (H1, H2) orientiert ist oder im Wesentlichen senkrecht zur ersten (H1) und senkrecht zur zweiten Hauptempfindlichkeitsrichtung (H2) orientiert ist.

5. Vorrichtung (100) nach einem der vorhergehenden Ansprüche, **dadurch gekennzeichnet, dass** der Magnetsensor (10) zur Prüfung eines Wertdokuments (1) ausgebildet ist, das mindestens einen ersten Magnetbereich (h) mit einer ersten Koerzitivfeldstärke und mindestens einen zweiten Magnetbereich (1) mit einer zweiten Koerzitivfeldstärke aufweist, wobei die erste Koerzitivfeldstärke größer ist als die zweite Koerzitivfeldstärke, und wobei, bei der Prüfung des Wertdokuments (1), mittels der ersten oder der zweiten Sensorzeile (12, 14) selektiv Magnetsignale des mindestens einen ersten Magnetbereichs (h) detektiert werden und wobei mittels der anderen dieser Sensorzeilen (12,14) selektiv Magnetsignale des mindestens einen zweiten Magnetbereichs (1) detektiert werden.

6. Vorrichtung (100) nach einem der vorhergehenden Ansprüche, **dadurch gekennzeichnet, dass** der erste Magnetisierungsabschnitt (A) eine erste Magnetfeldstärke und der zweite Magnetisierungsabschnitt (B) eine zweite Magnetfeldstärke aufweist, wobei die erste Magnetfeldstärke größer ist als die zweite Magnetfeldstärke, insbesondere um mindestens einen Faktor 1,5.

7. Vorrichtung (100) nach einem der vorhergehenden Ansprüche, **dadurch gekennzeichnet, dass** der erste Magnetisierungsabschnitt (A) eine erste Magnetfeldstärke aufweist, die größer als die erste und als die zweite Koerzitivfeldstärke ist und dass der zweite Magnetisierungsabschnitt (B) eine zweite Magnetfeldstärke aufweist, die kleiner als die erste Koerzitivfeldstärke aber größer als die zweite Koerzitivfeldstärke ist.

8. Vorrichtung (100) nach einem der vorhergehenden Ansprüche, **dadurch gekennzeichnet, dass** die erste Magnetisierungsrichtung und die zweite Magnetisierungsrichtung im Wesentlichen senkrecht zueinander orientiert sind und vorzugsweise im Wesentlichen in der Transportebene des Wertdokuments (1) liegen, wobei die erste oder die zweite Magnetisierungsrichtungen insbesondere im Wesentlichen parallel zur Transportrichtung (T) des Wertdokuments (1) orientiert ist.

9. Vorrichtung (100) nach einem der vorhergehenden Ansprüche, **dadurch gekennzeichnet, dass** die erste oder die zweite Hauptempfindlichkeitsrichtung (H1, H2) im Wesentlichen parallel zur Transportebene und im Wesentlichen senkrecht zur Transportrichtung (T) orientiert ist und dass die andere dieser Hauptempfindlichkeitsrichtungen (H1, H2) vorzugsweise im Wesentlichen parallel zur Transportrichtung (T) oder im Wesentlichen senkrecht zur Transportebene orientiert ist.

10. Vorrichtung (100) nach einem der vorhergehenden, **dadurch gekennzeichnet, dass** die erste oder die zweite Hauptempfindlichkeitsrichtung (H1, H2) im Wesentlichen parallel oder antiparallel zur ersten oder zur zweiten Magnetisierungsrichtung orientiert ist und dass die andere dieser Hauptempfindlichkeitsrichtungen (H1, H2) entweder im Wesentlichen parallel oder antiparallel zur anderen Magnetisierungsrichtung orientiert ist oder im Wesentlichen senkrecht zur ersten und zur zweiten Magnetisierungsrichtung orientiert ist.

11. Vorrichtung (100) nach einem der vorhergehenden Ansprüche, **dadurch gekennzeichnet, dass** die Vorrichtung eine Magnetisierungseinrichtung (20) aufweist, die zumindest den ersten Magnetisierungsabschnitt (A) bereit stellt, wobei die Magnetisierungseinrichtung (20) entlang des Transportwegs (S) des Wertdokuments (1) vor dem Magnetsensor (10), insbesondere räumlich getrennt von dem Magnetsensor (10), angeordnet ist.

12. Vorrichtung (100) nach einem der vorhergehenden Ansprüche, **dadurch gekennzeichnet, dass** die weitere Magnetisierungsrichtung m Wesentlichen parallel oder antiparallel zur ersten oder zur zweiten Magnetisierungsrichtung orientiert ist oder im Wesentlichen senkrecht zur ersten und zur zweiten Magnetisierungsrichtung orientiert ist.

13. Vorrichtung (100) nach einem der vorhergehenden Ansprüche, **dadurch gekennzeichnet, dass** die erste oder die zweite Sensorzeile (12, 14) in dem zweiten Magnetisierungsabschnitt (B) angeordnet ist, wobei die Hauptempfindlichkeitsrichtung (H1, H2) dieser ersten oder zweiten Sensorzeile (12, 14) im Wesentlichen senkrecht zur zweiten Magnetisierungsrichtung des zweiten Magnetisierungsabschnitts (B) orientiert ist.

14. Verfahren zur Prüfung eines Wertdokuments (1), das mindestens einen ersten Magnetbereich (h) mit einer ersten Koerzitivfeldstärke und mindestens einen zweiten Magnetbereich (1) mit einer zweiten Koerzitivfeldstärke aufweist, wobei die erste Koerzitivfeldstärke größer ist als die zweite Koerzitivfeldstärke, mit folgenden Schritten:
- Transportieren des Wertdokuments (1) in einer Transportrichtung (T) entlang eines Transportwegs (S), wobei das Wertdokument durch einen ersten Magnetisierungsabschnitt (A) und danach durch einen zweiten Magnetisierungsabschnitt (B) transportiert wird, und
- Detektieren von Magnetsignalen des Wertdokuments (1) durch einen Magnetsensor (10), der eine erste und eine zweite Sensorzeile (12, 14) und ggf. eine dritte Sensorzeile aufweist,
**dadurch gekennzeichnet,**
- **dass** mittels einer der ersten oder zweiten Sensorzeilen (12, 14) selektiv Magnetsignale des mindestens einen ersten Magnetbereichs (h) detektiert werden und mittels der anderen dieser Sensorzeilen (12,14) selektiv Magnetsignale des mindestens einen zweiten Magnetbereichs (1) detektiert werden, und
- **dass** in unmittelbarer Nähe zur ersten, zur zweiten oder zur dritten Sensorzeile ein weiterer Magnetisierungsabschnitt (C) angeordnet ist, der zur Magnetisierung des Wertdokuments (1) in eine weitere Magnetisierungsrichtung ausgebildet ist, wobei der weitere Magnetisierungsabschnitt (C) dazu ausgebildet ist, das Wertdokument (1), während der Detektion des Wertdokuments (1) durch die erste (12), durch die zweite (14) oder durch die dritte Sensorzeile (16), zu magnetisieren.

15. Verfahren nach Anspruch 14, **dadurch gekennzeichnet, dass** die Prüfung des Wertdokuments (1) mittels einer Vorrichtung (100) nach einem der Ansprüche 1 bis 13 durchgeführt wird.

## Claims

1. An apparatus (100) for checking a document of value (1) having
- a transport system for transporting the document of value (1) in a transport direction (T) along a transport path (S), wherein the document of value (1) spans a transport plane, and
- a first magnetization section (A) for magnetizing the document of value (1) in a first magnetization direction and a second magnetization section (B) for magnetizing the document of value (1) in a second magnetization direction, wherein the second magnetization section (B) is arranged, along the transport path (S), after the first magnetization section (A), and
- a magnetic sensor (10)
**characterized in that**
- the magnetic sensor has a first sensor line (12) which has several magneto-sensitive elements (13) with a first main sensitivity direction (H1), and which has a second sensor line (14) which has several magneto-sensitive elements (15) with a second main sensitivity direction (H2) which is different from the first main sensitivity direction (H1), and, where applicable, has a third sensor line, and
- that the apparatus, in particular the magnetic sensor (10), has a further magnetization section (C) which is configured to magnetize the document of value (1) in a further magnetization direction, wherein the further magnetization section (C) is configured to magnetize the document of value (1) during the detection of the document of value (1) by the first (12), by the second (14) or by the third sensor line (16).

2. The apparatus (100) according to claim 1, **characterized in that** the first main sensitivity direction (H1) is oriented substantially perpendicular to the second main sensitivity direction (H2).

3. The apparatus (100) according to any of the preceding claims, **characterized in that** the magnetic sensor (10) has a third sensor line (16) which has several magneto-sensitive, in particular magneto-resistive, elements (17) with a third main sensitivity direction (H3).

4. The apparatus (100) according to claim 3, **characterized in that** the third main sensitivity direction (H3) is oriented in particular either substantially parallel to the first or to the second main sensitivity direction (H1, H2) or is oriented substantially perpendicular to the first (H1) and perpendicular to the second main sensitivity direction (H2).

5. The apparatus (100) according to any of the preceding claims, **characterized in that** the magnetic sensor (10) is configured to check a document of value (1) which has at least one first magnetic area (h) having a first coercive field strength and at least one second magnetic area (1) having a second coercive field strength, wherein the first coercive field strength is greater than the second coercive field strength, and wherein, upon the checking of the document of value (1), by means of the first or of the second sensor line (12, 14) there are selectively detected magnetic signals of the at least one first magnetic area (h) and wherein by means of the other of the said sensor lines (12, 14) there are selectively detected magnetic signals of the at least one second magnetic area (1).

6. The apparatus (100) according to any of the preceding claims, **characterized in that** the first magnetization section (A) has a first magnetic field strength and the second magnetization section (B) a second magnetic field strength, wherein the first magnetic field strength is greater than the second magnetic field strength, preferably by at least a factor 1.5.

7. The apparatus (100) according to any of the preceding claims, **characterized in that** the first magnetization section (A) has a first magnetic field strength which is greater than the first and than the second coercive field strength and that the second magnetization section (B) has a second magnetic field strength which is smaller than the first coercive field strength but greater than the second coercive field strength.

8. The apparatus (100) according to any of the preceding claims, **characterized in that** the first magnetization direction and the second magnetization direction are oriented substantially perpendicular to each other and preferably lie substantially in the transport plane of the document of value (1), wherein the first or the second magnetization directions are oriented in particular substantially parallel to the transport direction (T) of the document of value (1).

9. The apparatus (100) according to any of the preceding claims, **characterized in that** the first or the second main sensitivity direction (H1, H2) is oriented substantially parallel to the transport plane and substantially perpendicular to the transport direction (T), and the other of said main sensitivity directions (H1, H2) is oriented preferably substantially parallel to the transport direction (T) or substantially perpendicular to the transport plane.

10. The apparatus (100) according to any of the preceding claims, **characterized in that** the first or the second main sensitivity direction (H1, H2) is oriented substantially parallel or antiparallel to the first or to the second magnetization direction and that the other of said main sensitivity directions (H1, H2) is oriented either substantially parallel or antiparallel to the other magnetization direction or is oriented substantially perpendicular to the first and to the second magnetization direction.

11. The apparatus (100) according to any of the preceding claims, **characterized in that** the apparatus has a magnetization device (20) which provides at least the first magnetization section (A), wherein the magnetization device (20) is arranged, along the transport path (S) of the document of value (1), before the magnetic sensor (10), in particular spatially separated from the magnetic sensor (10).

12. The apparatus (100) according to any of the preceding claims, **characterized in that** the further magnetization direction is oriented substantially parallel or antiparallel to the first or to the second magnetization direction or substantially perpendicular to the first and to the second magnetization direction.

13. The apparatus (100) according to any of the preceding claims, **characterized in that** the first or the second sensor line (12, 14) is arranged in the second magnetization section (B), wherein the main sensitivity direction (H1, H2) of said first or second sensor line (12, 14) is oriented substantially perpendicular to the second magnetization direction of the second magnetization section (B).

14. A method for checking a document of value (1) which has at least a first magnetic area (h) with a first coercive field strength and at least a second magnetic area (1) with a second coercive field strength, wherein the first coercive field strength is greater than the second coercive field strength, having the following steps:
- transporting the document of value (1) in a transport direction (T) along a transport path (S), wherein the document of value is transported through a first magnetization section (A) and then through a second magnetization section (B), and
- detecting magnetic signals of the document of value (1) by a magnetic sensor (10), which has a first and a second sensor line (12, 14) and, where applicable, a third sensor line,
**characterized in**
- **that** by means of one of the first or second sensor lines (12, 14) there are selectively detected magnetic signals of the at least one first magnetic area (h), and by means of the other of the said sensor lines (12, 14) there are selectively detected magnetic signals of the at least one second magnetic area (1), and
- **that** in close proximity to the first, to the second or to the third sensor line there is arranged a further magnetization section (C) which is configured to magnetize the document of value (1) in a further magnetization direction, wherein the further magnetization section (C) is configured to magnetize the document of value (1) during the detection of the document of value (1) by the first (12), by the second (14) or by the third sensor line (16).

15. The method according to claim 14, **characterized in that** the checking of the document of value (1) is carried out by means of an apparatus (100) according to any of claims 1 to 13.

## Revendications

1. Dispositif (100) de vérification d'un document de valeur (1) comprenant
- un système de transport pour le transport du document de valeur (1) dans une direction de transport (T) le long d'une voie de transport (S), le document de valeur (1) déployant un plan de transport, et
- une première section de magnétisation (A) pour la magnétisation du document de valeur (1) dans une première direction de magnétisation et une deuxième section de magnétisation (B) pour la magnétisation du document de valeur (1) dans une deuxième direction de magnétisation, la deuxième section de magnétisation (B) étant agencée le long de la voie de transport (S) après la première section de magnétisation (A), et
- un capteur magnétique (10)
**caractérisé en ce que**
- le capteur magnétique comporte une première rangée de capteurs (12) qui comporte plusieurs éléments magnéto-sensibles (13) ayant une première direction de sensibilité principale (H1) et comporte une deuxième rangée de capteurs (14) qui comporte plusieurs éléments magnéto-sensibles (15) ayant une deuxième direction de sensibilité principale (H2) qui est différente de la première direction de sensibilité principale (H1) et comporte le cas échéant une troisième rangée de capteurs, et
- le dispositif, notamment le capteur magnétique (10), comporte une section supplémentaire de magnétisation (C) qui est conçue pour la magnétisation du document de valeur (1) dans une direction supplémentaire de magnétisation, la section supplémentaire de magnétisation (C) étant conçue pour magnétiser le document de valeur (1) durant la détection du document de valeur (1) par la première (12), par la deuxième (14) ou par la troisième rangée de capteurs (16).

2. Dispositif (100) selon la revendication 1, **caractérisé en ce que** la première direction de sensibilité principale (H1) est orientée essentiellement perpendiculairement à la deuxième direction de sensibilité principale (H2).

3. Dispositif (100) selon une des revendications précédentes, **caractérisé en ce que** le capteur magnétique (10) comporte une troisième rangée de capteurs (16) qui comporte plusieurs éléments (17) magnéto-sensibles, notamment magnétorésistifs, ayant une troisième direction de sensibilité principale (H3).

4. Dispositif (100) selon la revendication 3, **caractérisé en ce que** la troisième direction de sensibilité principale (H3) est notamment orientée soit essentiellement parallèlement à la première ou à la deuxième direction de sensibilité principale (H1, H2), soit essentiellement perpendiculairement à la première (H1) et perpendiculairement à la deuxième direction de sensibilité principale (H2).

5. Dispositif (100) selon une des revendications précédentes, **caractérisé en ce que** le capteur magnétique (10) est conçu pour la vérification d'un document de valeur (1) qui comporte au moins une première zone magnétique (h) présentant une première intensité de champ coercitif et au moins une deuxième zone magnétique (l) présentant une deuxième intensité de champ coercitif, la première intensité de champ coercitif étant supérieure à la deuxième intensité de champ coercitif, et, lors de la vérification du document de valeur (1), des signaux magnétiques de la au moins une première zone magnétique (h) étant sélectivement détectés au moyen de la première ou de la deuxième rangée de capteurs (12, 14) et des signaux magnétiques de la au moins une deuxième zone magnétique (I) étant sélectivement détectés au moyen de l'autre de ces rangées de capteurs (12, 14).

6. Dispositif (100) selon une des revendications précédentes, **caractérisé en ce que** la première section de magnétisation (A) présente une première intensité de champ magnétique et la deuxième section de magnétisation (B) présente une deuxième intensité de champ magnétique, la première intensité de champ magnétique étant supérieure à la deuxième intensité de champ magnétique, notamment d'au moins un facteur de 1,5.

7. Dispositif (100) selon une des revendications précédentes, **caractérisé en ce que** la première section de magnétisation (A) présente une première intensité de champ magnétique qui est supérieure à la première et à la deuxième intensité de champ coercitif et **en ce que** la deuxième section de magnétisation (B) présente une deuxième intensité de champ magnétique qui est inférieure à la première intensité de champ coercitif mais supérieure à la deuxième intensité de champ coercitif.

8. Dispositif (100) selon une des revendications précédentes, **caractérisé en ce que** la première direction de magnétisation et la deuxième direction de magnétisation sont orientées essentiellement perpendiculairement l'une à l'autre et se trouvent de préférence essentiellement dans le plan de transport du document de valeur (1), la première ou la deuxième direction de magnétisation étant notamment orientée essentiellement parallèlement à la direction de transport (T) du document de valeur (1).

9. Dispositif (100) selon une des revendications précédentes, **caractérisé en ce que** la première ou la deuxième direction de sensibilité principale (H1, H2) est orientée essentiellement parallèlement au plan de transport et essentiellement perpendiculairement à la direction de transport (T) et **en ce que** l'autre de ces directions de sensibilité principale (H1, H2) est orientée de préférence essentiellement parallèlement à la direction de transport (T) ou essentiellement perpendiculairement au plan de transport.

10. Dispositif (100) selon une des revendications précédentes, **caractérisé en ce que** la première ou la deuxième direction de sensibilité principale (H1, H2) est orientée essentiellement parallèlement ou antiparallèlement à la première ou à la deuxième direction de magnétisation et **en ce que** l'autre de ces directions de sensibilité principale (H1, H2) est orientée soit essentiellement parallèlement ou antiparallèlement à l'autre direction de magnétisation, soit essentiellement parallèlement à la première et à la deuxième direction de magnétisation.

11. Dispositif (100) selon une des revendications précédentes, **caractérisé en ce que** le dispositif comporte un équipement de magnétisation (20) qui met au moins à disposition la première section de magnétisation (A), l'équipement de magnétisation (20) étant agencé le long de la voie de transport (S) du document de valeur (1) avant le capteur magnétique (10), notamment de manière spatialement séparée du capteur magnétique (10).

12. Dispositif (100) selon une des revendications précédentes, **caractérisé en ce que** la direction supplémentaire de magnétisation est orientée essentiellement parallèlement ou antiparallèlement à la première ou à la deuxième direction de magnétisation ou essentiellement perpendiculairement à la première et à la deuxième direction de magnétisation.

13. Dispositif (100) selon une des revendications précédentes, **caractérisé en ce que** la première ou la deuxième rangée de capteurs (12, 14) est agencée dans la deuxième section de magnétisation (B), la direction de sensibilité principale (H1, H2) de cette première ou deuxième rangée de capteurs (12, 14) étant orientée essentiellement perpendiculairement à la deuxième direction de magnétisation de la deuxième section de magnétisation (B).

14. Procédé de vérification d'un document de valeur (1) qui comprend au moins une première zone magnétique (h) présentant une première intensité de champ coercitif et au moins une deuxième zone magnétique (I) présentant une deuxième intensité de champ coercitif, la première intensité de champ coercitif étant supérieure à la deuxième intensité de champ coercitif, comportant les étapes:
- transport du document de valeur (1) dans une direction de transport (T) le long d'une voie de transport (S), le document de valeur étant transporté à travers une première section de magnétisation (A) puis à travers une deuxième section de magnétisation (B), et
- détection de signaux magnétiques du document de valeur (1) par un capteur magnétique (10) qui comporte une première et une deuxième rangée de capteurs (12, 14) et le cas échéant une troisième rangée de capteurs,
**caractérisé en ce**
- **que**, au moyen d'une des première ou deuxième rangées de capteurs (12, 14), des signaux magnétiques de la au moins une première zone magnétique (h) sont sélectivement détectés, et, au moyen de l'autre de ces rangées de capteurs (12, 14), des signaux magnétiques de la au moins une deuxième zone magnétique (I) sont sélectivement détectés, et
- **que**, à proximité immédiate de la première, de la deuxième ou de la troisième rangée de capteurs, une section supplémentaire de magnétisation (C) conçue pour la magnétisation du document de valeur (1) dans une direction supplémentaire de magnétisation est agencée, la section supplémentaire de magnétisation (C) étant conçue pour magnétiser le document de valeur (1) durant la détection du document de valeur (1) par la première (12), par la deuxième (14) ou par la troisième rangée de capteurs (16).

15. Procédé selon la revendication 14, **caractérisé en ce que** la vérification du document de valeur (1) est effectuée au moyen d'un dispositif (100) selon une des revendications de 1 à 13.
